# EUROPÄISCHE PATENTSCHRIFT

(11) **EP 1 792 527 B1**
(45) Veröffentlichungstag und Bekanntmachung des Hinweises auf die Patenterteilung: **16.04.2008**
(21) Anmeldenummer: 05782725.5
(22) Anmeldetag: 07.09.2005
(51) Int. Cl.: H05K 1/02, H03H 3/02, F16F 15/00

(54) **VORRICHTUNG UND VERFAHREN ZUR SCHWINGUNGSBEEINFLUSSUNG EINES FLÄCHENELEMENTES**
DEVICE AND METHOD FOR INFLUENCING VIBRATION OF A PLANAR ELEMENT
DISPOSITIF ET PROCEDE DESTINES A INFLUENCER LES OSCILLATIONS D'UN ELEMENT PLAT

(30) Priorität: 23.09.2004 DE 102004046150
(43) Veröffentlichungstag der Anmeldung: 06.06.2007
(73) Patentinhaber: Fraunhofer-Gesellschaft zur Förderung der angewandten Forschung e.V., 80686 München (DE)
(72) Erfinder: MELZ, Tobias, 64285 Darmstadt (DE); MAYER, Dirk, 64295 Darmstadt (DE)
(74) Vertreter: Rösler, Uwe
(86) Internationale Anmeldenummer: PCT/EP2005/009589
(87) Internationale Veröffentlichungsnummer: WO 2006/032363

(56) Entgegenhaltungen:
- EP-A- 0 806 589
- EP-A- 1 310 700
- US-A- 5 315 203
- US-A- 5 473 214
- US-B1- 6 359 372
- US-B1- 6 486 589

## Beschreibung

### Technisches Gebiet

Die vorliegende Erfindung betrifft eine Vorrichtung und ein Verfahren zur Schwingungsbeeinflussung eines Flächenelementes, das zwei gegenüberliegende Oberflächen und eine zwischen beiden Oberflächen verlaufende neutrale Faserebene aufweist, mit zumindest einem Aktor und zumindest einem Sensor, die jeweils Wandlerwerkstoffe aufweisen und die mit einem elektronischen Bauelement oder einer elektronischen Baugruppe verbunden sind. Als Flächenelement kommt bevorzugt eine Leiterplatte in Betracht.

### Stand der Technik

Vorrichtungen zur Beeinflussung von mechanisch schwingenden Flächenelementen werden in zahlreichen technischen Gebieten, wie beispielsweise in der Akustik, im Automobilbau oder in der Luft- und Raumfahrt eingesetzt.

Die zunehmende Vernetzung des klassischen Maschinenbaus mit der Informationstechnik, besonders in den Disziplinen der Mechatronik und der Adaptronik führt zu einer vermehrten Verwendung von elektronischen Baugruppen auf Leiterplatten beispielsweise in den Bereichen des Automobilbaus, der Luft- und Raumfahrt, aber auch der Werkzeugmaschinenherstellung. Bei Anregung von Resonanzen der Leiterplatte können durch die auftretenden mechanischen Schwingungen der Leiterplatte elastische Verformungen bewirkt werden, die zu erheblichen Dehnungen und Stauchungen längs der Oberfläche der Leiterplatte führen. Dabei werden auf der Oberfläche vorhandene Leiterbahnen sowie applizierte elektronische Bauelemente belastet. Durch Rissbildungen oder Schädigungen an den Leiterbahnen kann die Leiterplatte selbst beschädigt werden, Löt- und andere Verbindungen können versagen, applizierte Bauteile können durch die mechanischen Spannungen geschädigt werden oder sich lösen und so zu einem Versagen der elektronischen Baugruppe führen. Daher besteht ein Bedarf an Verfahren zur Dämpfung derartiger Vibrationen in den elektronischen Baugruppen.

Bekannt sind passive Vorrichtungen zur Schwingungsbeeinflussung von Flächenelementen, beispielsweise durch eine spezielle Konstruktionsauslegung, wie mechanische Versteifungen in Form von Verstrebungen, oder durch Verwendung schwingungsdämpfender Materialien in den jeweiligen Flächenelementen. Daneben sind Vorrichtungen bekannt, die eine mechanische Schwingungsentkoppelung von Flächenelementen von ihrer Umgebung bewirken, beispielsweise durch Verwendung geeigneter Halterungen.

Derartige passive Vorrichtungen zur Schwingungsbeeinflussung finden aufgrund ihrer Effizienz zu Zwecken der Dämpfung ungewollter mechanischer Schwingungen breite Anwendung. Nachteilig sind jedoch der hierfür erforderliche zusätzliche Raumbedarf sowie das zusätzliche Gewicht. Darüber hinaus ist die Effektivität der Schwingungsbeeinflussung von der zu beeinflussenden Schwingungsfrequenz abhängig. Im Allgemeinen nimmt die Effektivität bei niedrigen Frequenzen deutlich ab, so dass der Einsatz passiver Systeme für Anwendungen unterhalb Frequenzen von einigen 100 Hz nicht möglich ist.

Bekannte alternative Methoden zur Schwingungsbeeinflussung von Flächenelementen nutzen aktive Systeme, die typischerweise mindestens einen Sensor und einen Aktor vorsehen, die mit einer Regeleinheit verbunden sind. Der Sensor sowie der Aktor stehen dabei in Wirkverbindung mit dem Flächenelement. Im Allgemeinen bilden die genannten Komponenten einen Regelkreis, der es erlaubt den Aktor basierend auf den vom Sensor erfassten Signalen, definiert zu steuern. Mit dem Sensor werden direkt oder indirekt die Amplitude, die Frequenz sowie die Phasenlage der Schwingungen des Flächenelements erfasst. Sollen beispielsweise vorhandene Schwingungen eines Flächenelements gedämpft werden, so werden dem Aktor Steuersignale zugeleitet, die eine bestimmte Phasenlage, Frequenz und Amplitude relativ zu den Sensor-Signalen aufweisen, durch die im Flächenelement Gegenschwingung induziert werden, die die Schwingungen des Flächenelementes kompensieren. Der Aktor kann auch zur Anregung und Verstärkung definierter Schwingungen eines Flächenelements oder zur Einleitung definierter Scher-, Druck-und Zugkräfte auf das Flächenelement genutzt werden.

Zur Schwingungsbeeinflussung von Flächenelementen mit geringen Flächenelementdicken haben sich als Aktoren piezoelektrische Wandler als besonders geeignet erwiesen. So werden derartige Aktoren mit verschiedenen piezoelektrischen Materialien in unterschiedlichen Formen und Größen, insbesondere in Form flächiger piezoelektrischer Wandler eingesetzt. Als Sensoren werden unterschiedliche Bauelemente wie Beschleunigungsaufnehmer, Dehnungsmessstreifen oder ebenfalls piezoelektrische Wandler verwendet. Der Vorteil des Einsatzes von Wandlerwerkstoffen zur Schwingungsbeeinflussung von Flächenelementen liegt unter anderem in deren geringer Gewicht und Größe, sowie deren Einsetzbarkeit bei Schwingungsfrequenzen von einigen Hz bis einigen kHz.

Aus der Druckschrift US 4,565,940 geht eine gattungsgemäße Vorrichtung hervor, bei der ein organische Polymere mit piezoelektrischen Eigenschaften aufweisender Aktor eingesetzt wird. Derartige organische Polymere, wie beispielsweise Polyvinylidene Fluorid (PVF₂), werden zumeist als Folien ausgebildet. In der beschriebenen Vorrichtung ist eine PVF₂-Folie auf einer Oberfläche eines Flächenelementes angebracht, die als piezoelektrischer Aktor dient. Als Sensor werden Beschleunigungsmesser oder Dehnungsmessstreifen, die ebenfalls auf der Oberfläche des Flächenelements angebracht sind, eingesetzt. Durch den lediglich auf einer Seite eines Flächenelementes aufgebrachten piezoelektrischen Folienaktor werden somit nicht nur Biegemomente, sondern auch Längskräfte in das Flächenelement eingeleitet. Indem sich beide Effekte überlagern, wird die Effektivität der aktiven Schwingungsbeeinflussung jedoch nachteilhaft beeinflusst.

Um dieses Problem zu lösen, wird in der Druckschrift EP 0 806 589 vorgeschlagen, neben der Applizierung eines piezoelektrischen Aktors auf der Oberfläche eines Flächenelementes, einen Beschleunigungssensor anzubringen, der die Schwingungen erfasst und der auf der freien Oberfläche des Aktors befestigt ist. Der Aktor sowie der damit verbundene Sensor werden derart auf der Oberfläche des Flächenelementes angebracht, dass Aktor und Sensor im Wesentlichen im maximalen Schwingungsbauch, der sich bei resonanter Anregung des Flächenelementes ausbildet, platziert sind. Bei dieser Vorrichtung besteht jedoch weiterhin der Nachteil, dass durch die Anordnung des Aktors sowie des darauf angebrachten Sensors Oberflächenanteile des Flächenelementes verloren gehen, die für anderweitige Nutzungen wünschenswert wäre.

Ferner geht aus der Europäischen Druckschrift EP 0 975 891 eine Leiterplattenanordnung mit aktiver Schwingungsdämpfung hervor, bei der Aktoren auf Stützelementen aufgebracht sind, um möglichst viel Fläche der Leiterplatte für die eigentliche Elektronik zur Verfügung zu stellen. Durch die Anbringung auf Stützelementen werden die Aktoren jedoch beschädigungsanfällig platziert. Darüber hinaus wird das Einbringen gezielter Aktorkräfte in das Flächenelement durch die Stützelemente erschwert. EP-A-0806589, offenbart eine Vorrichtung mit den im ersten Teil des Anspruchs 1 genannten Merkmalen.

Alle aktiven Vorrichtungen zur Schwingungsbeeinflussung eines Flächenelements erfordern zur Ansteuerung der Aktoren und / oder der Sensoren eine Leistungselektronik.

Die bekannten Vorrichtungen und Verfahren zur Schwingungsbeeinflussung eines Flächenelementes, insbesondere für eine Leiterplatte, bei denen Aktoren und/ oder Sensoren eingesetzt werden, weisen zusammengefasst folgende Nachteile auf:
- Die Aktoren und Sensoren sind direkt oder indirekt auf der Oberfläche des Flächenelements befestigt und überdecken diese zumindest teilweise. Der hierfür erforderliche Flächenbedarf geht für eine andersartige Verwendung, beispielsweise für weitere elektronische Bauelemente, verloren. Zudem sind die auf der Oberfläche angeordneten Aktoren und Sensoren beschädigungsanfällig gegenüber äußeren Einflüssen exponiert angebracht, insbesondere in dem Fall, dass die Aktoren oder Sensoren auf Stützelementen aufgebracht sind.
- Durch das Anbringen der Aktoren und Sensoren auf nur einer Seite der Oberfläche des Flächenelements werden nicht nur Biegemomente, sondern auch Längskräfte eingeleitet bzw. sensiert. Indem sich beide Effekte überlagern, wird die Effektivität der aktiven Schwingungsbeeinflussung beeinträchtigt.
- Die Aktoren und / oder Sensoren werden innerhalb eines elektrischen Regelkreises eingesetzt. Die Ansteuerung der Aktoren und / oder der Sensoren erfordert eine Leistungselektronik und verbraucht zusätzliche elektrische Energie.

### Darstellung der Erfindung

Die Aufgabe der vorliegenden Erfindung besteht darin, eine Vorrichtung und ein Verfahren zur Schwingungsbeeinflussung eines Flächenelements, vorzugsweise in Form einer Leiterplatte, mit zumindest einem Aktor und zumindest einem Sensor, die jeweils Wandlerwerkstoffe aufweisen, derart anzugeben, dass möglichst kein Platz durch Vorsehen von Aktoren oder Sensoren auf der Oberfläche des Flächenelementes verloren geht. Ferner sollen weitgehend nur Biegeschwingungen innerhalb des Flächenelements erfassbar und gezielt beeinflussbar sein. Darüber hinaus soll eine Schwingungsbeeinflussung des Flächenelements ohne die Notwendigkeit einer Leistungselektronik möglich sein.

Die Lösung der der Erfindung zugrunde liegenden Aufgabe ist im Anspruch 1 angegeben. Gegenstand des Anspruchs 15 und des Anspruchs 18 ist jeweils ein Verfahren zur Schwingungsbeeinflussung eines Flächenelementes. Den Erfindungsgedanken vorteilhaft weiterbildende Merkmale sind Gegenstand der Unteransprüche sowie der Beschreibung insbesondere unter Bezugnahme auf die Ausführungsbeispiele zu entnehmen.

Die erfindungsgemäße Vorrichtung zur Schwingungsbeeinflussung eines Flächenelements, das zwei gegenüberliegende Oberflächen und eine zwischen beiden Oberflächen verlaufende neutrale Faserebene aufweist, mit zumindest einem Aktor und zumindest einem Sensor, die jeweils Wandlerwerkstoffe aufweisen, zeichnet sich dadurch aus, dass der Aktor und der Sensor von beiden Oberflächen sowie von der neutralen Faserebene jeweils beabstandet innerhalb des Flächenelements vollständig integriert sind.

Die neutrale Faserebene bezeichnet dabei die Gesamtheit aller Punkte innerhalb eines Flächenelementes, in denen bei einer Biegung des Flächenelementes keine Zugspannungen oder Druckspannungen auftreten, d.h. in einem Flächenelement gibt es bei eingebrachten Biegespannungen, beispielsweise aufgrund mechanischer Schwingungen des Flächenelementes genau eine Schichtebene, die weder gedehnt noch gestaucht wird und damit ihre Längenerstreckung nicht verändert. In einem Flächenelement aus homogenem Material verläuft die neutrale Faserebene durch die Massenschwerpunkte der Flächenelementquerschnitte.

Zur erfindungsgemäßen vollständigen Einbringung von Sensoren und Aktoren in das Flächenelement eignen sich nur Bereiche innerhalb des Flächenelements, die von der Oberfläche sowie von der neutralen Faserebene beabstandet sind, zumal nur in diesen Bereichen Druck- und Zugspannungen auftreten, die von Sensoren erfassbar sind. Gleichsam vermag ein Aktor nur in diesen Bereichen Zug- und Druckspannungen in das Flächenelement einzubringen, wodurch Biegemomente gezielt in das Flächenelement aufbringbar sind. Die entstehenden Druck- und Zugspannungen innerhalb des Flächenelements nehmen dabei unter Annahme linearer elastischer Eigenschaften des Fläehenelementmaterials gemäß dem Hookschen Gesetz proportional mit größer werdendem Abstand von der neutralen Faserebene zur Oberfläche hin zu. Die Wirksamkeit der Aktoren und Sensoren, die als piezoelektrische Wandler ausgebildet sind, ist daher bei einer möglichst oberflächennahen Integration am größten.

Im Unterschied zum Aufbringen der Aktoren oder Sensoren auf der Oberfläche des Flächenelements, wobei über eine derart bekannte Verbindung nur Scherkräfte vermittelt werden können, werden durch vollständiges Umschließen der eingesetzten piezoelektrischen Wandler durch das Flächenelementmaterial die aktiv induzierten oder passiv erfahrenen Längenänderungen des Wandlers dem Flächenelementmaterial als Zug- und Druckkräfte vermittelt. Durch die Zug- und Druckkräfte wird eine direkte Einbringung bzw. Erfassung von Biegemomenten innerhalb des Flächenelements ermöglicht, was die Wirksamkeit der Sensoren oder Aktoren erheblich verbessert.

Die erfindungsgemäße Vorrichtung zur Schwingungsbeeinflussung eines Flächenelementes kann sowohl zur Schwingungsanregung als auch zur Schwingungsdämpfung benutzt werden. Dabei sind aktive, semi-passive und semi-aktive Ausführungsformen möglich.
Bei der aktiven Ausführungsform der erfindungsgemäßen Vorrichtung erzeugen Biegeschwingungen des Flächenelementes im Sensor elektrische Signale die von der Amplitude, der Frequenz und Phasenlage der Biegeschwingung des Flächenelements abhängen. Der Sensor ist elektrisch mit einer Regeleinheit verbunden. Die vom Sensor erzeugten elektrischen Signale werden in Form elektrischer Signale an die Regeleinheit weitergeleitet. In der Regeleinheit werden die elektrischen Signale ausgewertet und auf deren Basis elektrische Steuersignale für den Aktor erzeugt. Der Aktor ist gleichsam mit der Regeleinheit verbunden. Sensor, Regeleinheit und Aktor bilden somit einen Regelkreis. Je nach Anwendung kann der erfindungsgemäß in das Flächenelement integrierte Aktor beispielsweise zu Änderungen seiner Längserstreckung mit einer bestimmten Amplitude, Frequenz und Phasenlage angeregt werden, so dass Druck- und Zugspannungen in dem Flächenelement erzeugt werden, die relativ zu den vorhandenen Schwingungen des Flächenelementes gegenphasige Biegeschwingungen verursachen, und so vorhandene Schwingungen des Flächenelementes dämpfen. Es können andererseits dadurch vom Aktor auch definierte Druck- und Zugspannungen in das Flächenelement eingebracht werden, die definierte Biegeschwingungen des Flächenelementes anregen oder verstärken.

Bei einer semi-passiven Ausführungsform der erfindungsgemäßen Vorrichtung werden piezoelektrische Wandler als Aktor und/ oder Sensor erfindungsgemäß in das Flächenelement eingebracht und mit zumindest einem geeigneten resistiven Bauelement oder einer solchen Baugruppe verbunden. Die Wirkungsweise dieser Ausführungsform der Vorrichtung lässt sich durch eine Energiebetrachtung veranschaulichen. Die mechanische Schwingungsenergie des Flächenelementes, wird durch dabei im Flächenelement auftretende Druck- und Zug kräfte, die ihrerseits auf den piezoelektrischen Wandler wirken, von diesem in elektrische Energie umgewandelt. Durch die Verbindung des piezoelektrischen Wandlers mit einem resistiven Bauelement, wird die elektrische Energie wiederum vom resistiven Bauelement in thermische Energie umgewandelt. Dadurch wird dem mechanischen Schwingungssystem Energie entzogen. Da die Energie eines schwingenden Systems von der Amplitude der Schwingung abhängt, führt ein Energieentzug zu einer Reduktion der Amplitude und somit zu einer Dämpfung der Schwingung.

Bei der semi-aktiven Ausführungsform der erfindungsgemäßen Vorrichtung zur Schwingungsbeeinflussung eines Flächenelements werden piezoelektrische Wandler erfindungsgemäß in das Flächenelement integriert und zumindest mit einem geeigneten induktiven Bauelement oder einer aktiven Schaltung , die derartige Bauelemente simuliert, verbunden. Durch die kapazitiven Eigenschaften der piezoelektrischen Wandler und deren Verbindung mit zumindest einem induktiven Bauelement, bildet sich ein elektrischer Schwingkreis aus. Die im piezoelektrischen Wandler durch Schwingungen des Flächenelementes entstehenden elektrischen Ladungen schwingen zwischen dem induktiven Bauelement und dem piezoelektrischem Wandler hin und her. Es kommt somit zu einem periodischen Austausch zwischen magnetischer und elektrischer Energie, so dass ein angeregtes Schwingungssystem mit zwei Freiheitsgraden vorliegt, bei dem sich der so genannte Tilgereffekt einstellt, der bei der sog. Tilgerfrequenz zu einer Schwingungsdämpfung durch den piezoelektrischen Wandler und damit zu einer Dämpfung der Schwingung des Flächenelementes führt. Vorteilhaft ist insbesondere, dass keinerlei Leistungselektronik benötigt wird, so dass sämtliche hierfür erforderlichen Bauelemente gemeinsam mit den piezoelektrischen Wandlern in das Flächenelement bzw. die Leiterplatte zu integrieren sind.

### Kurze Beschreibung der Erfindung

Die Erfindung wird nachstehend ohne Beschränkung des allgemeinen Erfindungsgedankens anhand eines Ausführungsbeispiels und unter Bezugnahme auf die Zeichnungen exemplarisch beschrieben. Es zeigen:
- Fig. 1: schematisierte Querschnittsdarstellung durch eine schwingende Leiterplatte zur Darstellung der auftretenden Biegemomente, der Zug-und Druckspannungen sowie der neutralen Faserebene,
- Fig. 2 a - b: schematisierte Querschnittsdarstellung durch eine Leiterplatte zur Darstellung einer erfindungsgemäßen Anordnungen und Verwendung von einem piezoelektrischen Wandler in dem Flächenelement,
- Fig. 3 a - g: schematisierte Querschnittsdarstellung durch eine Leiterplatte zur Darstellung verschiedener erfindungsgemäßer Anordnungen von einem Aktor und einem Sensor, oder von zwei Aktoren, oder von zwei Sensoren in einem Flächenelement,
- Fig. 4: schematisierte Querschnittsdarstellung durch eine Leiterplatte zur Darstellung der Anordnung von zwei piezoelektrischen Wandlern, die von einer Regeleinheit sowohl als Aktor angesteuert, wie auch als Sensor zur Erfassung von Schwingungen des Flächenelementes eingesetzt werden,
- Fig. 5: schematisierte Darstellung eines Regelkreises bestehend aus einer Anordnung von zwei Aktor-Sensorpaaren in dem Flächenelement sowie der Verschaltung mit einer Regeleinheit,
- Fig. 6: schematisierte Darstellung einer semi-passiven Ausführungsform der Erfindung durch Beschaltung eines piezoelektrischen Wandlers mit einem resistiven Bauelement, und
- Fig. 7: schematisierte Darstellung einer semi-passiven Ausführungsform der Erfindung durch Beschaltung eines piezoelektrischen Wandlers mit einem induktiven Bauelement.

### Wege zur Ausführung der Erfindung

Die erfindungsgemäße Vorrichtung zur Schwingungsbeeinflussung eines Flächenelementes sowie das damit durchführbare Verfahren eignen sich insbesondere für die Dämpfung von Biegeschwingungen bei Leiterplatten.

Im Allgemeinen bestehen Leiterplatten nicht aus homogenem Material sondern aus Verbundwerkstoffen, insbesondere aus Faserverbundwerkstoffen mit Glasfasern. Die Dicken solcher Leiterplatten liegen typischerweise zwischen 1 bis 5 mm mit typischen maximalen Flächendimensionen unter 2500 cm². Leiterplatten eignen sich daher aufgrund ihrer Herstellung aus verschiedenen Materialien sehr gut zur Integration von entsprechend dünnen piezoelektrischen Wandlem.

Bei den erfindungsgemäß in das Flächenelement integrierten Aktoren und Sensoren sind jeweils piezoelektrische Wandler eingesetzt, die flächig ausgebildet sind, mit einer Flächengröße von bis zu 14 cm² und einer Flächendicke zwischen 0,1 und 0,4mm. Sie weisen Elektroden zur elektrischen Stromversorgung auf und zeichnen sich insbesondere dadurch aus, dass bei Anlegen einer elektrischen Spannung an die Elektroden, der flächige piezoelektrische Wandler im Wege des piezoelektrischen Effekts eine Längenänderung erfährt, während eine Dickenänderung des Wandlers weitgehend vernachlässigbar ist. Durch die Formgebung der flächigen Wandler sowie die Formgebung der Elektroden können Freiheitsgrade geschaffen werden, mit denen die Regelung sowie die Wirksamkeit zur Schwingungsbeeinflussung angepasst bzw. optimiert werden können.

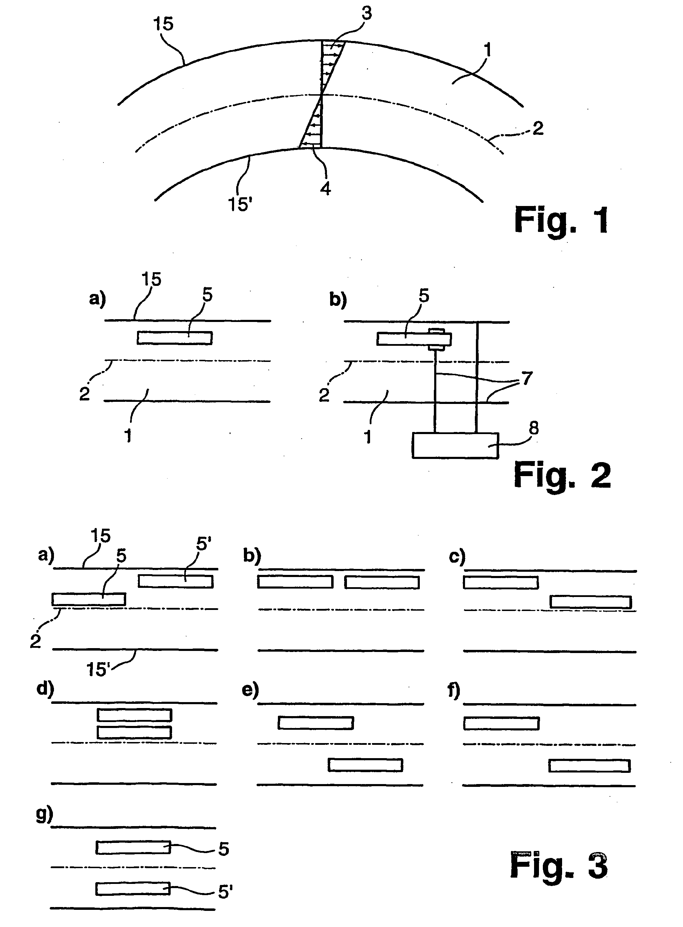

Zur Darstellung der allgemein bekannten mechanischen Spannungsverhältnisse innerhalb einer Leiterplatte bei Biegeschwingungen ist in Figur 1 ein schematisierter Querschnitt durch eine gebogene Leiterplatte 1 dargestellt. Die dargestellte Biegung der Leiterplatte 1 erzeugt in der oberen Hälfte des Querschnitts Zugkräfte 3, die zu einer Dehnung des Leiterplattenmaterials führen, und in der unteren Hälfte des Querschnitts Druckkräfte 4, die zu einer Stauchung des Leiterplattenmaterials führen. Die entstehenden Druck- 4 und Zugkräfte 3 nehmen in Richtung der beiden Oberflächen 15, 15' zu und verschwinden bei der neutralen Faser 2. Die Zug- 3 und Druckkräfte 4 üben auf ein jeweils senkrecht zur neutralen Faserebene 2 stehendes Flächenelement Biegespannungen aus und erzeugen damit ein auf die neutrale Faser 2 bezogenes Drehmoment.

Wird nun erfindungsgemäß ein flächiger piezoelektrischer Wandler derart in die Leiterplatte integriert, dass er parallel zur neutralen Faserebene angeordnet und von der neutralen Faserebene und von der Oberfläche beabstandet ist, wirken auf den Wandler entsprechende Zug- oder Druckkräfte des umgebenden Materials. Wird der piezoelektrische Wandler in seiner Länge durch Zugkräfte vergrößert oder durch Druckkräfte verkleinert, so entstehen jeweils auf der Oberfläche des Wandlers Ladungen und damit an den Elektroden des Wandlers abgreifbare Spannungen. Andererseits erfährt ein erfindungsgemäß integrierter piezoelektrischer Wandler, der mit einer elektrischen Spannung beaufschlagt wird, eine Längenänderung, wodurch Zug- und Druckkräfte parallel zur neutralen Faserebene auf das den piezoelektrischen Wandler umgebende Material übertragen und dadurch Biegemomente erzeugt werden.

Figur 2a zeigt die erfindungsgemäße Integration nur eines piezoelektrischen Wandlers 5 in eine Leiterplatte 1, wobei der Wandler 5 parallel zur neutralen Faserebene 2 und von der Oberfläche 15 und der neutralen Faserebene 2 beabstandet angeordnet ist.

Figur 2b zeigt eine erfindungsgemäße Vorrichtung mit einem piezoelektrischen Wandler 5, bei der der Wandler 5 mit einer Regeleinheit 8 durch elektrische Verbindungen 7 verbunden ist, die den Wandler 5 sowohl als Sensor wie auch als Aktor ansteuert. Unter Verwendung einer Messbrücke ist es möglich das Piezosignal in einen aktorischen als auch sensorischen Anteil aufzutrennen, so dass ein einziger piezoelektrischer Wandler sowohl als Sensor wie auch als Aktor betreibbar ist.

Die erfindungsgemäße Anordnung von einem piezoelektrischen Wandler 5 in der Leiterplatte 1 führt dazu, dass nicht nur Biegemomente, sondern auch Längskräfte in die Leiterplatte 1 eingeleitet bzw. erfasst werden. Aufgrund der Überlagerung beider Effekte wird die Schwingungsbeeinflussung nachteilhaft beeinflusst. Das Problem bei der überlagerten Einleitung von Biegemomenten und Längskräften gestaltet sich derart, dass ein zum Aktor kollokiert angebrachter Sensor nicht nur Biegedehnungen, sondern auch Längsdehnungen misst. Letztere verursachen mitunter ein sehr starkes Signal am Sensor, sind aber nicht das Ziel der Schwingungsregelung. Der Regelkreis regelt daher vornehmlich eine Größe, die nicht von Interesse ist. Eine Minimierung des Sensorsignals hat daher nichts bis wenig mit einer Verringerung der Biegeschwingung zu tun.

Die Anforderungen an die Regeleinheit können erheblich reduziert und die Effektivität der Schwingungsbeeinflussung zudem gesteigert werden, indem mindestens zwei piezoelektrische Wandler in die Leiterplatte integriert sind.

In Figur 3 a bis g sind schematisierte Querschnitte durch eine Leiterplatte 1 zur Darstellung verschiedener erfindungsgemäßer Anordnungen von jeweils zwei parallel zur neutralen Faserebene angeordneten piezoelektrischen Wandlern 5 gezeigt. Aus Gründen einer übersichtlicheren Darstellung wurden dabei Bezugszeichen nur in die Figur 3a eingetragen. Für die weitem Figuren 3b bis 3g sind diese analog übertragbar. Die Figuren 3a bis 3d zeigen Anordnungen, bei denen jeweils zwei Wandler 5, 5' in einem Halbraum der Leiterplatte 1, zwischen der neutralen Faserebene 2 und einer Oberfläche 15 der Leiterplatte 1 angeordnet sind. Dabei zeigt:
- Figur 3a: zwei Wandler 5, 5', die nebeneinander, nicht überlappend in unterschiedlichen Abständen zur neutralen Faserebene 2 angeordnet sind,
- Figur 3b: zwei Wandler 5, 5', die nebeneinander, nicht überlappend in gleichen Abständen zur neutralen Faserebene 2 angeordnet sind,
- Figur 3c: zwei Wandler 5, 5', die teilweise überlappend in unterschiedlichen Abständen zur neutralen Faserebene 2 angeordnet sind, und
- Figur 3d: zwei Wandler 5, 5', die überlappend in unterschiedlichen Abständen zur neutralen Faserebene 2 angeordnet sind.

Die Figuren 3e bis 3g zeigen Anordnungen von zwei Wandlern 5, 5', die in jeweils unterschiedlichen Halbräumen einer Leiterplatte 1, die durch die neutrale Faserebene 2 getrennt sind, angeordnet sind. Dabei zeigt:
- Figur 3e: zwei Wandler 5, 5', die senkrecht relativ zur neutralen Faserebene 2 teilweise überlappend angeordnet sind,
- Figur 3f: zwei Wandler 5, 5', die senkrecht relativ zur neutralen Faserebene 2 nicht überlappend angeordnet sind, und
- Figur 3g: zwei Wandler 5, 5', die senkrecht relativ zur neutralen Faserebene 2 vollständig überlappend angeordnet sind.

Zusätzliche Variationen ergeben sich bei den Anordnungen der Figuren 3e bis 3g durch jeweils unterschiedliche oder gleiche Abstände der zwei Wandler 5, 5' von der neutralen Faserebene 2.

Die Anordnung der zwei Wandler 5, 5' in Figur 3g ist von allen in den Figuren 3 a bis g dargestellten Anordnungsmöglichkeiten am besten für eine Schwingungsdämpfung einer Leiterplatte 1 geeignet, sofern die Wandler mit einer Regeleinheit 8 elektrisch verbundenen sind, durch die sie sowohl als Sensor wie auch als Aktor betrieben werden können. Beide Wandler 5, 5' sind jeweils senkrecht relativ zur neutralen Faserebene 2 vollständig überlappend angeordnet sind und vorzugsweise an einer Position in der Leiterplatte 1 integriert, die mit einem maximalen Schwingungsbauch zusammenfällt, der sich resonanter Schwingungsanregung der Leiterplatte ergibt.

Alle weiteren Anordnungen 3e, 3f, bei denen die zwei Wandler 5, 5' relativ zur neutralen Faserebene 2 gegenseitig nicht überlappend angeordnet sind, führen zu erhöhten Anforderungen an die Regeleinheit 8, um das angestrebte Ziel einer gezielten Schwingungsbeeinflussung zu erreichen

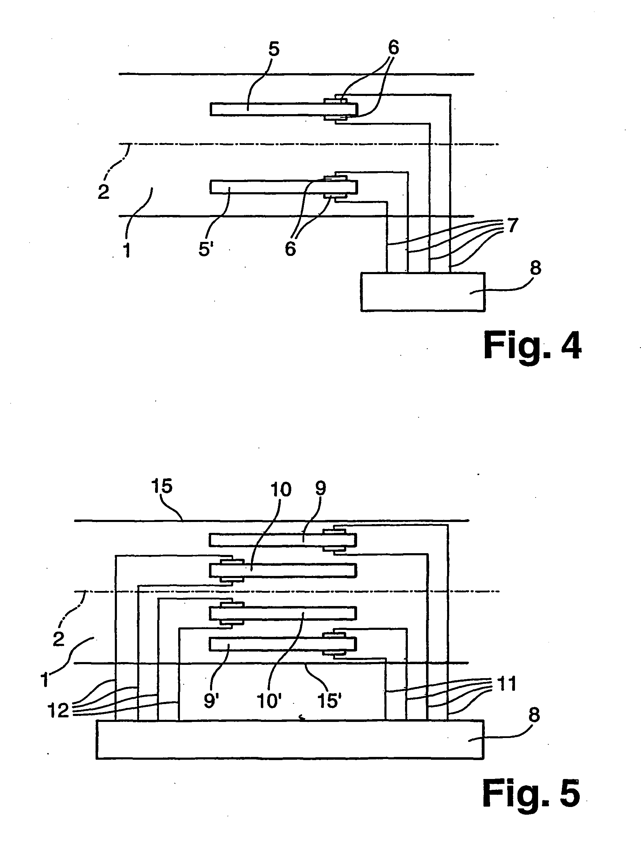

In Figur 4 ist eine Ausführungsform der erfindungsgemäßen Vorrichtung mit zwei piezoelektrischen Wandlern 5, 5' in einer der Figur 3g entsprechenden Anordnung schematisch dargestellt. Dabei weisen die flächigen piezoelektrischen Wandler 5, 5' an ihren beiden Oberflächen jeweils Elektrodenkontakte 6 auf, die über elektrische Verbindungen 7 mit einer entsprechenden Regeleinheit 8 verbunden sind. Die Regeleinheit 8 steuert die Wandler 5, 5' in der eben ausgeführten Weise an.

In Figur 5 ist schematisch eine weitere vorteilhafte Weiterbildung der Vorrichtung dargestellt. Dabei sind zwei Aktor-Sensorpaare 9/10, 9'/10' vorgesehen, die jeweils aus einem Aktor 9, 9' und einem Sensor 10, 10' bestehen und jeweils zwischen einer Oberfläche 15, 15' und der neutralen Faserebene 2 derart positioniert sind, dass der Aktor 9, 9' und der Sensor 10, 10' parallel zur neutralen Faserebene 2 orientiert und senkrecht relativ zur neutralen Faserebene 2 gegenseitig überlappend angeordnet sind. Dabei sind die zwei Aktor-Sensorpaare symmetrisch zur neutralen Faserebene 2 in der Leiterplatte 1 integriert. Die Sensoren sind über die elektrischen Verbindungen 12, die Aktoren über die elektrischen Verbindungen 11 mit einer Regeleinheit 8 verbunden. Durch gegenphasiges Ansteuern der Aktoren 9, 9' durch die Regeleinheit 8 wird die Einleitung von Längskräften in die Leiterplatte 1 kompensiert, während die Größe des eingeleiteten Biegemoments verdoppelt wird. Damit die Sensoren 10, 10' ausschließlich Biegeschwingungen erfassen, wird entweder über eine externe Beschaltung die Differenz beider Sensorsignale gebildet oder einer der Sensoren 10, 10' wird bezogen auf seine Polarisationsrichtung umgekehrt, d.h. 180° verdreht gegenüber dem anderen Sensor in die Leiterplatte 1 integriert, wodurch dessen Ausgangsspannung bei gleicher Verformung gegenphasig ist. Eine Parallelschaltung aus beiden Sensoren 10, 10' führt letztlich zu einer Aufhebung der Ladungen, die durch Längsdehnung der Leiterplatte 1 erzeugt werden, während sich die Ladungen, die durch die Biegeschwingungen der Leiterplatte 1 entstehen, addieren. Der Vorteil dieser Ausführungsform ist die ausschließliche Beeinflussung der Biegeschwingung der Leiterplatte 1.

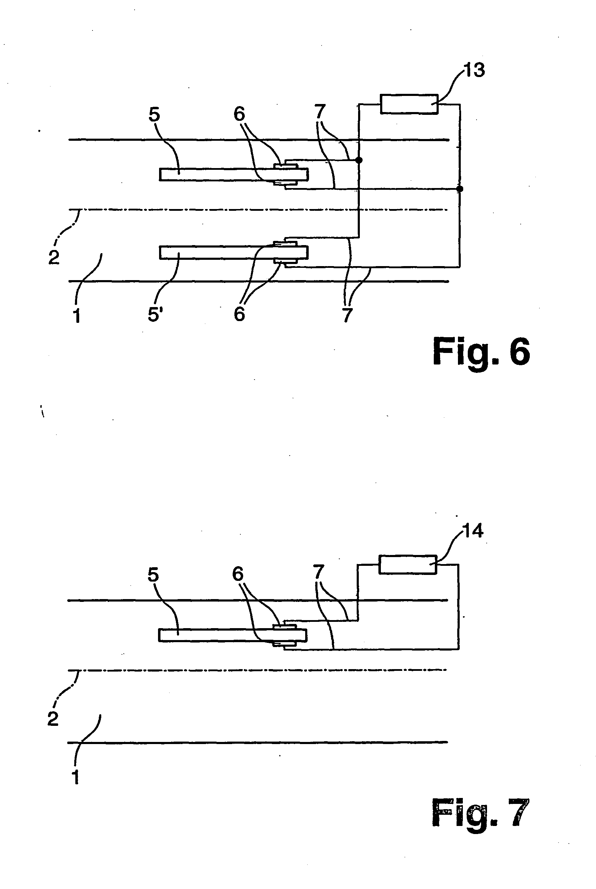

In einer semi-passiven Weiterbildung der erfindungsgemäßen Vorrichtung gemäß Figur 6, sind zwei piezoelektrischer Wandler 5, 5' überlappend und symmetrisch zur neutralen Faser in die Leiterplatte 1 integriert. Die Elektroden 6 der Wandler 5, 5' sind über elektrische Verbindungen 7 mit einem resistiven Bauelement 13 oder einer aktiven Schaltung, die ein solches Bauelement simuliert, verbunden. Bei der schwingenden Leiterplatte 1 wird die mechanische Schwingungsenergie der Leiterplatte 1 zunächst mit Hilfe des direkten piezoelektrischen Effekts in den beiden Wandlern 5, 5' in elektrische Energie umgewandelt, die anschließend über das resistive Bauelement 13 in Wärme umgesetzt wird. Durch eine Biegung der Leiterplatte 1 während des Schwingens beispielsweise nach oben, wird der oberhalb der neutralen Faserebene 2 integrierte Wandler 5 gedehnt, während der unterhalb der neutralen Faserebene 2 integrierte Wandler 5' gestaucht wird. Die gegensätzlichen Änderungen der Längserstreckung der Wandler 5, 5' und die dadurch auf der Oberfläche des Wandler 5, 5' entstehenden Ladungen bzw. elektrischen Spannungen, werden wie in der Figur 6 dargestellt mit dem resistiven Bauelement 13 verschaltet. Damit wird der mechanischen Schwingung der Leiterplatte 1 Energie entzogen, die durch das resistive Bauelement 13 in Wärmeenergie umgewandelt wird. Dies führt zu einer sog. semi-passiven Dämpfung der Schwingungen der Leiterplatte 1.

In einer semi-aktiven Weiterbildung der erfindungsgemäßen Vorrichtung gemäß Figur 7, wird ein in die Leiterplatte 1 integrierter piezoelektrischer Wandler 5 mit seinen Elektroden 6 über die elektrischen Verbindungen 7 mit einem induktiven Bauelement 14 oder einer aktiven Schaltung, die ein solches Bauelement simuliert, verbunden. Bei dieser elektrischen Verschaltung entsteht durch die kapazitiven Eigenschaften des Wandlers 5 in Verbindung mit dem induktiven Bauelement 14 ein elektrischer Schwingkreis. Die Dämpfung der mechanischen Schwingung der Leiterplatte 1 wird durch Ausnutzung des bereits beschriebenen Tilgereffektes erzeugt.

Sowohl die semi-passive als auch die semi-aktive Dämpfung erfordern keine Leistungselektronik, daher bietet es sich an, die notwendigen Bauelemente zur Beschaltung der piezoelektrischen Wandler zusammen mit den vorhandenen Bauelementen in die Leiterplatte zu integrieren.

### Bezugszeichenliste

- **1**: Leiterplatte, Flächenelement
- **2**: Neutrale Faser, neutrale Faserebene
- **3**: Zug kräfte
- **4**: Druckkräfte
- **5, 5'**: Piezoelektrischer Wandler
- **6**: Kontaktelektrode auf der Oberfläche eines piezoelektrischen Wandlers
- **7**: Elektrische Verbindung
- **8**: Regeleinheit
- **9, 9**': Piezoelektrischer Wandler als Aktor
- **10, 10'**: Piezoelektrischer Wandler als Sensor
- **11**: Elektrische Verbindung zwischen Aktor und Regeleinheit
- **12**: Elektrische Verbindung zwischen Sensor und Regeleinheit
- **13**: resistives Bauelement
- **14**: induktives Bauelement
- **15,15'**: Oberfläche eines Flächenelements bzw. einer Leiterplatte

## Patentansprüche

1. Vorrichtung zur Schwingungsbeeinflussung eines Flächenelementes (1), das zwei gegenüberliegende Oberflächen (15, 15') und eine zwischen beiden Oberflächen (15, 15') verlaufende neutrale Faserebene (2) aufweist, mit zumindest einem Aktor (9) und zu mindest einem Sensor (10), die jeweils Wandlerwerkstoffe aufweisen und die wenigstens mit einem elektronischen Bauelement (8) verbunden sind,
**dadurch gekennzeichnet, dass** der Aktor (9) und der Sensor (10) von beiden Oberflächen (15, 15') sowie von der neutralen Faserebene (2) jeweils beabstandet innerhalb des Flächenelementes (1) vollständig integriert sind.

2. Vorrichtung nach Anspruch 1,
**dadurch gekennzeichnet, dass** der Abstand des Aktors (9) von einer der beiden Oberflächen (15, 15') geringer ist, als der Abstand des Aktors (9) von der neutralen Faserebene (2).

3. Vorrichtung nach einem der Ansprüche 1 bis 2,
**dadurch gekennzeichnet, dass** zumindest zwei Aktoren (9) vorgesehen sind, die symmetrisch zur neutralen Faserebene (2) in das Flächenelement (1) integriert sind.

4. Vorrichtung nach einem der Ansprüche 1 bis 3,
**dadurch gekennzeichnet, dass** zumindest zwei Sensoren (10) vorgesehen sind, die symmetrisch zur neutralen Faserebene (2) in das Flächenelement (1) integriert sind.

5. Vorrichtung nach einem der Ansprüche 1 bis 4,
**dadurch gekennzeichnet, dass** zumindest zwei Aktor-Sensorpaare vorgesehen sind, die jeweils aus einem Aktor (9) und einem Sensor (10) bestehen und jeweils zwischen einer Oberfläche (15) und der neutralen Faserebene derart angeordnet sind, dass der Aktor (9) und der Sensor (10) parallel zur neutralen Faserebene (2) orientiert und senkrecht relativ zur neutralen Faserebene (2) gegenseitig wenigstens teilweise überlappend angeordnet sind, und
dass die zumindest zwei Aktor-Sensorpaare symmetrisch zur neutralen Faserebene (2) in dem Flächenelement (1) integriert sind.

6. Vorrichtung nach einem der Ansprüche 1 bis 5,
**dadurch gekennzeichnet, dass** der Aktor (9) und der Sensor (10) jeweils als piezoelektrische Wandler (5) ausgebildet sind.

7. Vorrichtung nach einem der Ansprüche 1 bis 6,
**dadurch gekennzeichnet, dass** der Aktor (9) und der Sensor (10) flächig ausgebildet sind, mit einer Flächengröße von bis zu 14 cm² und einer Flächedicke zwischen 0,1 und 0,4 mm.

8. Vorrichtung nach einem der Ansprüche 1 bis 7,
**dadurch gekennzeichnet, dass** der Aktor (9) und der Sensor (10) in einer einzigen Baueinheit kombiniert sind, die als ein piezoelektrischer Wandler (5) ausgebildet ist.

9. Vorrichtung nach einem der Ansprüche 1 bis 8,
**dadurch gekennzeichnet, dass** die Baueinheit mit einer Steuereinheit verbunden ist, durch die die Baueinheit als wechselweise oder simultan als Aktor (9) und als Sensor (10) betreibbar ist.

10. Vorrichtung nach einem der Ansprüche 1 bis 9,
**dadurch gekennzeichnet, dass** das Flächenelement (1) eine elektrische Leiterplatte ist.

11. Vorrichtung nach einem der Ansprüche 1 bis 10,
**dadurch gekennzeichnet, dass** die elektrische Leiterplatte (19) faserverstärktes Verbundmaterial, insbesondere glasfaserverstärkten Kunststoff (GFK) aufweist.

12. Vorrichtung nach einem der Ansprüche 1 bis 11,
**dadurch gekennzeichnet, dass** der Sensor (10) und der Aktor (9) mit einer Regeleinheit (8) verbunden ist, die mit dem Aktor (9) und dem Sensor (10) einen Regelkreis bildet.

13. Vorrichtung nach einem der Ansprüche 1 bis 12,
**dadurch gekennzeichnet, dass** zumindest ein Sensor (10) oder zumindest ein Aktor (9) elektrisch mit zumindest einem induktiven (14) oder resistiven (13) elektrischen Bauelement verbunden ist.

14. Verwendung der Vorrichtung nach einem der Ansprüche 1 bis 13 zur Schwingungsdämpfung einer Leiterplatte (1).

15. Verfahren zur Schwingungsbeeinflussung eines Flächenelementes (1) mit zwei gegenüberliegenden Oberflächen (15,15') und einer zwischen beiden Oberflächen verlaufenden neutralen Faserebene (2) und mit zumindest einem Aktor (9) und zumindest einem Sensor (10), die jeweils einen Wandlerwerkstoff aufweisen und die mit wenigstens einem elektronischen Bauelement verbunden sind, **gekennzeichnet durch** folgende Verfahrensschritte:
- Bereitstellen eines Flächenelementes (1) in das wenigstens ein Aktor (9) und ein Sensor (10) derart integriert sind, dass der Aktor (9) und der Sensor (10) von beiden Oberflächen (15,15') sowie von der neutralen Faserebene (2) des Flächenelementes (1) beabstandet und parallel zu der neutralen Faserebene (2) platziert sind,
- Ermitteln von sich innerhalb des Flächenelementes (1) ausbildenden Schwingungen mittels des wenigstens einen Sensors (10) und
- Erzeugen von Schwingungen mittels des Aktors (9) zur Beeinflussung der sich in dem Flächenelement (1) ausgebildeten Schwingungen.

16. Verfahren nach Anspruch 15,
**dadurch gekennzeichnet, dass** die durch den Aktor (9) erzeugten Schwingungen in Form von Gegenschwingungen zu den sich innerhalb der Leiterplatte (1) ausgebildeten Schwingungen erzeugt werden.

17. Verfahren nach Anspruch 16,
**dadurch gekennzeichnet, dass** zur Erzeugung von Gegenschwingungen zwei, relativ zur neutralen Faserebene (2) gegenüberliegende, als piezoelektrische Wandler (5, 5') ausgebildete Aktoren (9) derart zur Längenänderung angeregt werden, so dass ihre Längenänderung jeweils gegenphasig zueinander erfolgt.

18. Verfahren zur Schwingungsbeeinflussung eines Flächenelementes (1) mit zwei gegenüberliegenden Oberflächen (15, 15') und einer zwischen beiden Oberflächen (15, 15') verlaufenden neutralen Faserebene (2) und mit zumindest zwei Bauelementen, die einen piezoelektrischen Werkstoff aufweisen und die mit wenigstens einem elektronischen Bauelement verbunden sind,
**gekennzeichnet durch** folgende Verfahrensschritte:
- Bereitstellen eines Flächenelementes (1) in das wenigstens ein Aktor (9) und ein Sensor (10) derart integriert sind, dass der Aktor (9) und der Sensor (10) von beiden Oberflächen (15, 15') sowie von der neutralen Faserebene (2) des Flächenelementes (1) beabstandet und parallel zu der neutralen Faserebene (2) platziert sind.
- Umwandeln wenigstens eines Teils der innerhalb des Flächenelementes (1) auftretenden Schwingungsenergie in elektrische Energie innerhalb der Bauelemente,
- Abführen der elektrischen Energie **durch** Umwandeln der elektrischen Energie in thermische Energie und Freisetzen der thermischen Energie.

19. Verfahren nach Anspruch 18,
**dadurch gekennzeichnet, dass** die Umwandlung der elektrischen Energie und die Freisetzung der thermischen Energie durch Verbinden der Bauelemente mit
wenigstens einem induktiven (14) oder resistiven (13) elektrischen Bauelement erfolgt.

## Claims

1. A device for influencing the vibration of a planar element having two opposite surfaces (15,15') and a neutral fiber plane (2) running between the two surfaces 15,15'), having at least one actuator (9) and at least one sensor (10) which each are provided with transducer materials and are connected to at least one electronic component (8),
wherein the actuator (9) and the sensor (10) are completely integrated in the planar element (1) at a distance from the two surfaces (15, 15') as well as from the
neutral fiber plane (2).

2. A device according to claim 1,
wherein the distance of the actuator (9) from one of the two surfaces (15, 15') is smaller than the distance of the actuator (9) from the neutral fiber plane (2).

3. A device according to one of the claims 1 to 2,
wherein at least two actuators (9) are provided, which are integrated in the planar element (1) symmetrically to the neutral fiber plane (2).

4. A device according to one of the claims 1 to 3,
wherein at least two sensors (10) are provided which are integrated in the planar element (1) symmetrically to the neutral fiber plane (2).

5. A device according to one of the claims 1 to 4,
wherein at least two pairs of actuators-sensors are provided which each comprise one actuator (9) and one sensor (10) and which are each disposed between a surface (15) and the neutral fiber plane in such a manner that the actuator (9) and the sensor (10) are oriented, at least partially overlapping each other, parallel to the neutral fiber plane (2) and perpendicular relative to the neutral fiber plane (2), and the at least two pairs of actuators-sensors are integrated symmetrically to the neutral fiber plane (2) in the planar element (1).

6. A device according to one of the claims 1 to 5,
wherein the actuator (9) and the sensor (10) are each designed as piezoelectric transducers (5).

7. A device according to one of the claims 1 to 6,
wherein the actuator (9) and the sensor (10) are designed planar with an areal size of up to 14 cm² and an areal thickness of between 0.1 and 0.4mm.

8. A device according to one of the claims 1 to 7,
wherein the actuator (9) and the sensor (10) are combined in a single module which is designed as a piezoelectric transducer (5).

9. A device according to one of the claims 1 to 8,
wherein the module is connected to a control unit by means of which the module is operable alternately or simultaneously as an actuator (9) and as a sensor (10).

10. A device according to one of the claims 1 to 9,
wherein the planar element (1) is an electric printed circuit board.

11. A device according to one of the claims 1 to 10,
wherein the electric printed circuit board (1) is provided with fiber-reinforced composite material, in particular glass-fiber- reinforced plastic (GFK).

12. A device according to one of the claims 1 to 11,
wherein the sensor (10) and the actuator (9) are connected to a control unit (8) which forms with the actuator (9) and the sensor (10) a control circuit.

13. A device according to one of the claims 1 to 12,
wherein at least one sensor (10) or at least one actuator (9) is connected to at least one inductive (14) or resistive (13) electrical component.

14. Use of the device according to one of the claims 1 to 13 for dampening the vibration of a printed circuit board (1).

15. A method for influencing the vibration of a planar element (1) having two opposite surfaces (15,15') and a neutral fiber plane (2) running between the two surfaces and having at least one actuator (9) and at least one sensor (10), which each are provided with transducer material and are connected to at least one electronic component,
**characterized by** the following method steps:
- provision of a planar element (1) in which at least one actuator (9) and one sensor (10) are integrated in such a manner that the actuator (9) and the sensor (10) are placed at a distance from the two surfaces (15,15') as well as from the neutral fiber plane (2) of the planar element (1) and parallel to the neutral fiber plane (2),
- detection by means of at least one sensor (10) of the vibrations forming inside the planar element (1) and
- generation of vibrations by means of the actuator (9) to influence the vibrations forming in the planar element (1).

16. A device according to claim 15,
wherein the vibrations generated by the actuator (9) are generated in the form of counter vibrations to the vibrations formed inside the printed circuit board (1).

17. A method according to claim 16,
wherein in order to generate counter vibrations, two actuators (9) lying opposite relative to the neutral fiber plane (2) and designed as piezoelectric transducers (5,5') are excited to change longitudinally in such a manner that the longitudinal change of each occurs anti-phase.

18. A method for influencing the vibration of a planar element (1) having two opposite surfaces (15,15') and a neutral fiber plane (2) running between the two surfaces (15, 15') and having at least two components which are provided with a piezoelectric material and which are connected to at least one electronic component,
**characterized by** the following method steps:
- provision of a planar element (1) in which at least one actuator (9) and one sensor (10) are integrated in such a manner that the actuator (9) and the sensor (10) are disposed at a distance from the two surfaces (15,15') as well as from the neutral fiber plane (2) of the planar element (1) and parallel to the neutral fiber plane (2),
- conversion of at least a part of the vibration energy occurring inside the planar element (1) into electric energy inside the components,
- removal of the electric energy by conversion of the electric energy into thermal energy and release of the thermal energy.

19. A method according to claim 18,
wherein the conversion of the electric energy and the release of the thermal energy occurs by connecting the components to at least one inductive (14) or resistive (13) electric component.

## Revendications

1. Dispositif pour influencer les oscillations d'un élément plat (1) qui présente deux surfaces opposées (15, 15') et un plan de fibres neutre (2) s'étendant entre les deux surfaces (15, 15'), comprenant au moins un actionneur (9) et au moins un capteur (10) présentant respectivement des matériaux de convertisseur et qui sont reliés à un composant électronique (8), **caractérisé en ce que** l'actionneur (9) et le capteur (10) sont intégrés entièrement de façon mutuellement espacée des deux surfaces (15, 15') et du plan de fibres neutre (2), à l'intérieur de l'élément plat (1).

2. Dispositif selon la revendication 1, **caractérisé en ce que** la distance de l'actionneur (9) de l'une des deux surfaces (15, 15') est inférieure à la distance de l'actionneur (9) du plan de fibres neutre (2).

3. Dispositif selon les revendications 1 et 2, **caractérisé en ce qu'**au moins deux actionneurs (9) son prévus, qui sont intégrés symétriquement au plan de fibres neutre (2) dans l'élément plat (1).

4. Dispositif selon l'une des revendications 1 à 3, **caractérisé en ce qu'**au moins deux capteurs (10) son prévus, qui sont intégrés symétriquement au plan de fibres neutre (2) dans l'élément plat (1).

5. Dispositif selon l'une des revendications 1 à 4, **caractérisé en ce qu'**au moins deux paires d'actionneurs-capteurs sont prévues qui sont composées respectivement d'un actionneur (9) et d'un capteur (10) et sont disposées respectivement entre une surface (15) et le plan de fibres neutre de telle manière que l'actionneur (9) et le capteur (10) sont orientés parallèlement au plan de fibres neutre (2) et se chevauchent réciproquement au moins partiellement et perpendiculairement par rapport au plan de fibres neutre (2) et que les au moins deux paires d'actionneur-capteur sont intégrées dans la carte de circuit imprimé (1) symétriquement par rapport au plan de fibres neutre (2).

6. Dispositif selon l'une des revendications 1 à 5, **caractérisé en ce que** l'actionneur (9) et le capteur (10) sont chacun des convertisseurs piézoélectriques (5).

7. Dispositif selon l'une des revendications 1 à 6, **caractérisé en ce que** l'actionneur (9) et le capteur (10) sont plats, avec une dimension de surface jusqu'à 14 cm² et une épaisseur de surface entre 0,1 et 0,4 mm.

8. Dispositif selon l'une des revendications 1 à 7, **caractérisé en ce que** l'actionneur (9) et le capteur (10) sont combinés dans un seul module qui est formé comme un convertisseur piézoélectrique (5).

9. Dispositif selon l'une des revendications 1 à 8, **caractérisé en ce que** le module est relié à une unité de commande permettant d'utiliser l'unité modulaire alternativement ou simultanément comme actionneur (9) et comme capteur (10).

10. Dispositif selon l'une des revendications 1 à 9, **caractérisé en ce que** l'élément plat (1) est une carte de circuit imprimé électrique.

11. Dispositif selon l'une des revendications 1 à 10, **caractérisé en ce que** la carte de circuit imprimé (19) électrique présente un matériau composite renforcé par fibres, particulièrement du plastique renforcé par fibres de verre.

12. Dispositif selon l'une des revendications 1 à 11, **caractérisé en ce que** le capteur (10) et l'actionneur (9) sont reliés à une unité de réglage (8) qui forme un circuit de réglage avec l'actionneur (9) et le capteur (10).

13. Dispositif selon l'une des revendications 1 à 12, **caractérisé en ce qu'**au moins un capteur (10) ou au moins un actionneur (9) sont reliés à au moins un composant électrique inductif (14) ou résistif (13).

14. Utilisation du dispositif selon l'une des revendications 1 à 13 pour amortir les oscillations d'une carte de circuit imprimé (1).

15. Procédé destiné à influencer les oscillations d'un élément plat (1) comprenant deux surfaces opposées (15, 15') avec un plan de fibres neutre (2) s'étendant entre les deux surfaces (15, 15'), comprenant au moins un actionneur (9) et au moins un capteur (10) présentant respectivement un matériau de convertisseur et qui sont reliés à au moins un composant électronique, **caractérisé par** les étapes suivantes :
- préparation d'un élément plat (1) dans lequel au moins un actionneur (9) et un capteur (10) sont intégrés de façon à ce que l'actionneur (9) et le capteur (10) soient mutuellement espacés des deux surfaces (15, 15') et du plan de fibres neutre (2), à l'intérieur de l'élément plat (1),
- détection d'oscillations se produisant à l'intérieur de l'élément plat (1) au moyen de l'au moins un capteur (10) et
- production d'oscillations au moyen de l'actionneur (9) pour influencer les oscillations formées dans l'élément plat (1).

16. Procédé selon la revendication 15, **caractérisé en ce que** les oscillations produites par l'actionneur (9) sont produites sous forme de contre-oscillations par rapport aux oscillations formées à l'intérieur de la carte de circuit imprimé (1).

17. Procédé selon la revendication 16, **caractérisé en ce que** pour produire les contre-oscillations, deux actionneurs (9) formés comme convertisseurs piézoélectriques (5, 5') opposés par rapport au plan de fibres neutre (2) sont ainsi excités pour modifier leur longueur, que leur modification en longueur s'effectue respectivement en contre-phase.

18. Procédé destiné à influencer les oscillations d'un élément plat (1) comprenant deux surfaces opposées (15, 15') avec un plan de fibres neutre (2) s'étendant entre les deux surfaces (15, 15'), et comprenant au moins deux composants qui présentent un matériau piézoélectrique et qui sont reliés à au moins un composant électronique, **caractérisé par** les étapes suivantes :
- préparation d'un élément plat (1) dans lequel au moins un actionneur (9) et un capteur (10) sont intégrés de façon à ce que l'actionneur (9) et le capteur (10) soient espacés des deux surfaces (15, 15') et du plan de fibres neutre (2) de l'élément plat (1) et soient placés parallèlement au plan de fibres neutre (2),
- conversion d'au moins une partie de l'énergie d'oscillation se produisant à l'intérieur de l'élément plat (1) en énergie électrique à l'intérieur des composants,
- évacuation de l'énergie thermique par la conversion de l'énergie électrique en énergie thermique et libération de l'énergie thermique.

19. Procédé selon la revendication 18, **caractérisé en ce que** la conversion de l'énergie électrique et la libération de l'énergie thermique s'effectue par une liaison des composants à au moins un composant électrique inductif (14) ou résistif (13).
